(19) Europäisches Patentamt
European Patent Office
Office européen des brevets

(11) EP 0 418 885 B1

(12) EUROPEAN PATENT SPECIFICATION

(45) Date of publication and mention of the grant of the patent:
**16.04.1997 Bulletin 1997/16**

(51) Int Cl.6: **H04L 7/08**

(21) Application number: **90118117.2**

(22) Date of filing: **20.09.1990**

# (54) Digital data transmitting apparatus

Gerät zur Übertragung von digitalen Daten

Appareil de transmission de données numériques

(84) Designated Contracting States:
**DE FR GB**

(30) Priority: **20.09.1989 JP 244468/89**

(43) Date of publication of application:
**27.03.1991 Bulletin 1991/13**

(73) Proprietor: **SONY CORPORATION**
**Tokyo (JP)**

(72) Inventors:
- **Suzuki, Hideto**
**Shinagawa,ku, Tokyo (JP)**
- **Kurose, Yoshikazu**
**Shinagawa,ku, Tokyo (JP)**
- **Aoki, Shinji**
**Shinagawa,ku, Tokyo (JP)**

(74) Representative:
**Schmidt-Evers, Jürgen, Dipl.-Ing. et al**
**Patentanwälte**
**Mitscherlich & Partner,**
**Postfach 33 06 09**
**80066 München (DE)**

(56) References cited:
**EP-A- 0 133 081**
**EP-A- 0 236 017**
**EP-A- 0 269 974**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

BACKGROUND OF THE INVENTION

1. Field of the Invention

The present invention relates to an apparatus for transmitting digital data inclusive of information data and synchronous data, and more particularly to an apparatus adapted for detecting a sync code in reproduced information data based on, for example, an ID-1 format.

2. Description of the Prior Art

An apparatus according to the precharacterizing part of claim 1 is described in EP-A-133081.

Relative to a recording/reproducing apparatus of a type designed to perform a high-density recording operation of information data, there is known a data recorder based on an ANSI ID-1 format (Third Draft, PROPOSED AMERICAN NATIONAL STANDARD 19mm TYPE ID-1 INSTRUMENTATION DIGITAL CASSETTE FORMAT X3B6/88-12 Project 592-D 1988-03-22).

In such a data recorder, error correction for the information data is effected by employing a product encoding notation with Reed-Solomon code and recording it on a magnetic tape, and in a playback mode, any transmission error is thereby detected and corrected.

Such data recorder will now be summarized below.

Fig. 1 illustrates an exemplary recording pattern formed on a magnetic tape by the data recorder based on the ID-1 format. In this diagram, ANN stands for an annotation track for recording notes thereon, and data tracks TR1, TR2, TR3, .... are for recording information data, wherein 1 sector is formed per data track. The data tracks are azimuth-recorded alternately. Further shown are a control track CTL for recording a control signal, and a time code track TC for recording a time code.

The content of each of the data tracks TR1, TR2, TR3, .... is so prescribed as illustrated in Fig. 2. Specifically, one data track TR corresponds to one sector SEC and is constituted of a preamble PR, a data recording portion DT and a postamble PS. The preamble PR is opposed to a lower top portion of the data track formed obliquely.

The preamble PR is composed of 20-byte ascending sequence RUS, 4-byte sync code $SYNC_{PR}$, 4-byte sector identification data $ID_{SEC1}$, and 6-byte auxiliary data $DT_{AUX}$.

The adjacent data recording portion DT is composed of 256 sync blocks BLK ($BLK_0$, $BLK_1$, $BLK_2$, .... $BLK_{255}$), and the input information data is recorded in this portion DT. Each sync block BLK is formed of a 4-byte block sync code $SYNC_{BLK}$, 1-byte block identification $ID_{BLK}$, 153-byte inner data DI (inner-coded input information data) and 8-byte parity code RI based on Reed-Solomon code notation.

The further adjacent postamble PS is composed of 4-byte sync code $SYNC_{PS}$ and 4-byte sector identification data $ID_{SEC2}$.

Fig. 3 shows a recording system of the ID-1 format data recorder. In this recording system 1, the input information data is recorded after being encoded for error correction by a product code notation.

The operation of each circuit is performed in the following manner. 8-bit (1-byte) input information data $DT_{USE}$ is inputted to an outer encoder 2. As shown in Fig. 4, this encoder 2 generates, by the use of a predetermined generating polynomial,with regard to the data blocks each composed of 118 bytes of the input information data $DT_{USE}$, outer codes which are parity codes $RO_0$-$RO_{305}$ each composed of 10-byte Reed-Solomon code. And such outer code is added to the end of each data block, which is thereafter outputted as an outer data block DO.

The outer data block DO is fed via a first multiplexer 3 to a memory unit 4. Fig. 5 shows the structure of the memory unit 4 and the data arrangement therein. As shown, the memory unit 4 consists of memories MEM1 and MEM2 each having a capacity of 154 bytes in a row and 128 bytes in a column. In this example, 153 outer data block $DO_0$ - $DO_{152}$ inputted sequentially are stored in the memory MEM1, while next 153 outer data blocks $DO_{153}$ - $DO_{305}$ inputted sequentially in succession to the outer data blocks $DO_0$ - $DO_{152}$ are stored in the memory MEM2 in such a manner that 1 outer data block is written per column. The information data of 1 outer data block is composed of 118 bytes and, since 153 blocks of the information data are written in each of the memories MEM1 and MEM2, it follows that a total of 118 x 153 x 2 bytes (= 36,108 bytes) of the information data are written in the memory unit 4.

The data writing direction in each column of the memories MEM1 and MEM2 is indicated by an arrow ARW1 in Fig. 5, and the lower 10 bytes in each of the memories MEM1 and MEM2 correspond to the outer code.

There are also fed, via the first multiplexer 3 to the memory unit 4, data block identification data $ID_B$ generated from an identification data generator 5 for identifying the individual rows in the memories MEM1 and MEM2. Even components $ID_{BE}$ of such data block identification data $ID_B$ are written in the memory MEM1 while odd components $ID_{BD}$ thereof are written in the memory MEM2 column by column in the direction ARW1.

The data thus written in the memories MEM1 and MEM2 are read out therefrom in the direction ARW2 in such a manner that the data of each row is processed as one block. The data reading operation for individual rows is performed alternately, with respect to the memories MEM1 and MEM2, in the order conforming to the data block identification data $ID_B$ (00, 01, 02, 03, ....) . The data read out from the memories MEM1 and MEM2 are inputted to an inner encoder 6.

This encoder 6 generates, by the use of a predetermined generating polynomial with regard to each of the input data blocks, inner codes which are parity codes $RI_0$ - $RI_{255}$ each composed of 8-byte Reed-Solomon code. As shown in Fig. 6, such inner codes are added to the ends of the data blocks respectively to form inner data blocks $DI_0$ - $DI_{255}$, which are then outputted to a second multiplexer 7.

The second multiplexer 7 selectively outputs the preamble data PR and the postamble data PS formed by a preamble/postamble generator 8 and also the inner data blocks $DI_0$ - $DI_{255}$ outputted from the inner encoder 6. Such data are outputted in the order of the preamble data PR, the inner data blocks $DI_0$ - $DI_{255}$ and the postamble data PS. The output of the second multiplexer 7 is fed to a data randomizer 9.

In the data randomizer 9, the data is randomized by taking an exclusive OR with regard to every byte of the input data and predetermined data. The data thus randomized is inputted to an 8-9 modulator 10.

In this modulator 10, the data constitution is converted from a 8-bit combination to an 9-bit combination for the purpose of achieving a DC-free state by removal of the DC component from the signal waveform to be recorded on the magnetic tape. Such conversion is performed in the following manner. With regard to each of 256 values of the input data where each byte is composed of 8 bits, two kinds of 9-bit data are previously determined on the basis of the ID-1 format. In such two kinds of 9-bit data, the codeword digital sums (CPS) thereof are different from each other in polarity. The 8-9 modulator 10 monitors the digital sum variation (DSV) of the 9-bit data outputted in accordance with the input data and selects either of the two kinds of 9-bit data having different CDS values, in such a way as to reduce the DSV value to zero. Thus, the input data of 8-bit combination is inverted into DC-free data of 9-bit combination. The 8-9 modulator 10 includes a circuit for converting the input data of NRZL (non-return to zero level) form into that of NRZI (non-return to zero inverse) form. The 9-bit output data of the 8-9 modulator 10 in NRZL form is inputted to a third multiplexer 11.

In the third multiplexer 11, a sync code $SYNC_B$ of a fixed 4-byte length obtained from a sync code generator 12 is added to each of the inner data blocks $DI_0$ - $DI_{255}$, whereby sync blocks $BLK_0$ - $BLK_{255}$ are formed. The pattern of such sync code $SYNC_B$ is determined on the basis of the ID-1 format, and the pattern to be recorded on the magnetic tape is so prescribed as to conform with such code pattern.

The data obtained in the above processes is shown in the form of maps in Fig. 6. The output of the third multiplexer 11 has a data array obtained by scanning such maps MAP1 and MAP2 in the horizontal direction. The further detail thereof is illustrated in Fig. 2. The output of the third multiplexer 11 is fed to a parallel-to-serial converter 13.

In the parallel-to-serial converter 13, the input bit-parallel data of preamble PR, sync blocks $BLK_0$ - $BLK_{255}$ and postamble PS is converted into bit-serial data $S_{REC}$. Such serial data $S_{REC}$ is amplified by a record amplifier 14 and then is supplied as a record signal to a magnetic head 16 which scans the magnetic tape 15 in a helical scanning mode, whereby record tracks TR (...., TR1, TR2, TR3, TR4, ....) are formed on the magnetic tape 15 as illustrated in Fig. 1.

In this manner, the recording system 1 in the data recorder is so constituted as to add an error correction code, which is based on the Reed-Solomon product code notation, to the desired information data $DT_{USE}$ to be recorded.

The information data $DT_{USE}$ thus recorded on the magnetic tape 15 by the recording system 1 of the data recorder is reproduced by a reproducing system 20 of the data recorder shown in Fig. 8.

The signal processing operation in the reproducing system 20 is exactly inverse to the operation performed in the recording system 1.

In the reproducing system 20 of the data recorder, the record tracks TR (...., TR1, TR2, TR3, TR4, ....) on the magnetic tape 15 are reproduced by the magnetic head 16 to become a playback signal $S_{PB}$, which is then inputted to a playback amplifier 21.

The playback amplifier 21 comprises an equalizer and a binary encoder, wherein playback digital data $DT_{PB}$ is obtained by encoding the input playback signal $S_{PB}$ in a binary notation and then is outputted to a serial-to-parallel converter 22. In this converter 22, the serial playback digital data $DT_{PB}$ is converted into 9-bit parallel data $DT_{PR}$.

In a sync code detector 23, the 4-byte sync code $SYNC_B$ is detected from a stream of the parallel data $DT_{PR}$, and the sync block is identified in accordance with the detected sync code. The sync code detector 23 includes a circuit for converting the NRZI-form parallel data $DT_{PR}$ into NRZL-form data.

The output of the sync code detector 23 is fed to an 8-9 demodulator 24, where the data processed by 8-to-9 bit conversion to be rendered DC-free in the recording system is demodulated to have an 8-bit combination again. The demodulator 24 is composed of a ROM (read-only memory) and converts the 9-bit data to 8-bit data by a table retrieval process.

The 8-bit data thus resumed is derandomized in a derandomizer 25 through a process inverse to the randomization executed in the recording system. Such derandomization is achieved by calculating an exclusive OR of the predetermined data used for the randomization and the input data fed to the derandomizer 25.

An inner code error detector/corrector 26 performs error detection and correction by using the 8-byte inner code $RI_0$ - $RI_{255}$ added respectively to the inner data blocks $DI_0$ - $DI_{255}$ out of the identified sync blocks.

The inner data blocks $DI_0$ - $DI_{255}$ subjected to such inner code error correction are written in a memory unit 28, which is structurally the same as the aforementioned memory unit 4 of the recording system shown in Fig. 5, on the basis of the 1-byte block identification data $ID_B$

added to each block detected by an identification data detector 27, in such a manner that one data block is written in one row. The data writing order is the same as the order of reading out the data from the memory unit 4 in the recording system, and the data blcoks are written in the memories MEM1 and MEM2 row by row alternately in conformity with the block identification data. The data thus written in the memories MEM1 and MEM2 of the memory unit 28 are read out therefrom in the direction of columns in the same order as the data writing order in the memory unit 4 of the recording system, and consequently the 128-byte outer data blocks $DO_0$ - $DO_{306}$ are resumed.

In an outer code error detector/corrector 29, error detection and correction are performed, with regard to the outer data blocks $DO_0$ - $DO_{306}$ outputted from the memory unit 28, by using the 10-byte outer code $RO_0$ - $RO_{306}$ added to the data blocks respectively.

Thus, the information data $DT_{USE}$ recorded on the magnetic tape 15 is reproduced in the manner described above.

In the reproducing system 20 of the data recorder of the constitution mentioned, the playback digital data $DT_{PB}$ inputted in the form of serial data are first converted into parallel data $DT_{PR}$ by the serial-to-parallel converter 22 and then are supplied to the 8-9 demodulator 24.

In the serial-to-parallel converter 22, various sync codes SYNC inserted at the interval of every predetermined byte length of the playback digital data $DT_{PB}$ are detected, and serial-to-parallel conversion is executed. Generally a demodulator 30 such as shown in Fig. 9 is constituted inclusive of the 8-9 demodulator 34.

More specifically, in the demodulator 30, the playback digital data $DT_{PB}$ in the serial form is inputted to both a serial-to-parallel converter 31 and a sync detector 32. In the sync detector 32, the timing of the sync code SYNC included in the playback digital data $DT_{PB}$ is detected, and the sync detection signal $S_{SYNC}$ obtained as a result of such detection is fed to a sync interpolator 33.

The sync interpolator 33 is composed of a flywheel counter and, in case the sync code SYNC fails to be detected due to some error, the sync detection signal $S_{SYNC}$ is interpolated in the time series mode, and simultaneously any false sync detection signal $ES_{SYNC}$ generated at an improper timing by some error is masked.

The proper sync detection signal $S_{SYNC}$ thus interpolated is inputted to the serial-to-parallel converter 31, where the playbadk digital data $DT_{PB}$ in the serial form is converted to parallel data $DT_{PB9}$ while being divided into, e.g., every 9 bits at the timing of the proper sync detection signal $S_{SYNC}$. Subsequently the parallel data $DT_{PB9}$ thus obtained is demodulated to parallel data $DT_{PB8}$, of which 1 byte is composed of 8 bits, by the 8-9 demodulator 34, and then is written in a memory 35 having such memory matrix as mentioned previously in connection with Fig. 5.

In the demodulator circuit 30, the sync detection signal $S_{SYNC}$ is fed to the serial-to-parallel converter 31 while being fed also to a block counter 36 consisting of row counters and column counters, thereby controlling the write addresses $ADR_{WR}$ of the parallel data $DT_{PB8}$ with regard to the memory 35.

It is generally customary that the sync code SYNC processed in such demodulator 30 is composed of 1 or 2 bytes, and therefore the probability of failure in detecting the sync code SYNC due to some error is relatively low, whereas the probability of generation of a false sync detection signal $ES_{SYNC}$ at an improper timing is relatively high.

However, in the magnetic data recorder employing the ID-1 format, each of the sync codes SYNC including the sync code $SYNC_{PR}$ of the preamble PR, the sync code $SYNC_{BLK}$ of the 256 sync blocks BLK in the data recording portion DT, and the sync code $SYNC_{PS}$ of the postamble PS, is determined to be 36 bits of a length of 4 bytes composed respectively of 9-bit data (5.4 Helical Record Content, Format, Synchronization, and Recording Method, pp. 7 - 11).

Therefore, in the case of employing the ID-1 format, the probability of generation of a failse sync detection signal $ES_{SYNC}$ is extremely low, whereas the probability of failure in detecting the sync code SYNC due to some error is high. It is derived from the fact that, as mentioned above, the sync code SYNC has a length of 36 bits.

Practically, if the initial sync code SYNC (i.e., the sync code $SYNC_{PR}$ of the preamble PR) of 1 sector SEC corresponding to one track fails to be properly detected, it is impossible to detect the block sync codes $SYNC_{BLK}$ of succeeding several blocks to thereby cause an error.

In this case, there arises a problem that, although the inner data DI itself in the sync block BLK is normal, due to the decision signifying the existence of an error in the block sync code $SYNC_{BLK}$, the inner data DI also is considered to be erroneous.

## OBJECTS AND SUMMARY OF THE INVENTION

The present invention has been accomplished in view of the problems described above. And its object is to provide an improved digital data transmitting apparatus which is capable of properly detecting a plural-byte sync code from the input digital data where both information data and synchronous data are included.

According to the present invention, there is provided an apparatus for transmitting digital data inclusive of information data and synchronous data as defined in claim 1.

In the digital data transmitting apparatus of the present invention, input data is first converted into desired parallel data, then each byte of the parallel data is compared with one byte of a sync code to predict the top bit position of the sync code, subsequently the parallel data is extracted by the byte length of the sync code in accordance with the result of such prediction, and the sync code in the input transmission data is detected. Thus, it becomes possible to perform accurate detection of the sync code without any wasteful comparison in regard to the entirety of the digital transmission data.

In case the sync code fails to be detected, the past sync code is interpolated on the basis of the detection information of the sync code detected successively thereto, whereby desired sync-code detection information can be obtained with certainty.

The above and other features of the present invention will become apparent from the following description which will be given with reference to the illustrative accompanying drawings.

## BRIEF DESCRIPTION OF THE DRAWINGS

Fig. 1 schematically illustrates a recording format on a magnetic tape;
Fig. 2 schematically illustrates the contents in each of record tracks;
Fig. 3 is a block diagram of a recording system in a magnetic recording/reproducing apparatus as a digital data recorder;
Fig. 4 schematically illustrates the output data of an outer encoder;
Fig. 5 is a schematic diagram showing a memory unit in the recording system;
Fig. 6 schematically illustrates the output data of an inner encoder;
Fig. 7 schematically illustrate data maps.
Fig. 8 is a block diagram of a reproducing system in a magnetic recording/reproducing apparatus as a digital data recorder;
Fig. 9 is a block diagram of a conventional demodulator;
Fig. 10 is a block diagram of a first embodiment of a demodulator in a magnetic recording/reproducing apparatus as a digital data recorder according to the present invention;
Fig. 11 is a table showing the selective switching operations of switch circuits employed in the first embodiment;
Fig. 12 is a block diagram of a sync detector in the first embodiment;
Figs. 13 and 14 are tables showing the sync detecting operation in the first embodiment;
Fig. 15 is a block diagram of a second embodiment of a demodulator;
Fig. 16 is a table showing the selective switching operations in the second embodiment;

## DESCRIPTION OF THE PREFERRED EMBODIMENTS

Hereinafter an exemplary embodiment of the present invention will be described in detail with reference to the accompanying drawings.

In the magnetic recording/reproducing apparatus or digital data recorder relative to this embodiment, information is recorded in conformity to the ID-1 format on a magnetic tape 14 as mentioned above in connection with Figs. 1 and 2. For example, in a 4-channel process, a maximum of 880 tracks are recorded per second, and the maximum repetition frequency of playback digital data $DT_{PB}$ becomes 88 MHz.

The bit error rate in such ID-1 format is supposed to be $10^{-4}$ as in another format termed SMPTE D-1. In this case, the probability of causing no error in the entire sync codes SYNC of 16-bit length can be expressed as

$$(1 - 10^{-4})^{36} \simeq 1 - 36 \times 10^{-4} \qquad (1)$$

It is found from the above that the probability of occurrence of an error in the sync code SYNC is $36 \times 10^{-4}$.

Meanwhile the block sync code $SYNC_{BLK}$ of the data portion DT is existent per second as

$$880 \times 256 = 225.28 \times 10^{3} \qquad (2)$$

It is thus calculated with regard to the probability that no-detection of the block sync code $SYNC_{BLK}$ due to random error, i.e., one continuous failure in detecting the block sync code $SYNC_{BLK}$ occurs once per track; two consecutive failures in detecting the block sync code $SYNC_{BLK}$ occur three times per second; and three consecutive failures in detecting the block sync code $SYNC_{BLK}$ occur once per 9.5 seconds.

Similarly, the calculated probability is such that four consecutive failures in detecting the block sync code $SYNC_{BLK}$ occur once per 7.3 hours, and five consecutive failures in detecting the block sync code $SYNC_{BLK}$ occur once per 84 days. It is further calculated that the probability of occurrence of five consecutive random errors and resultant failures in detecting the block sync code $SYNC_{BLK}$ is extremely low; whereas the probability of occurrence of three consecutive random errors and resultant failures in detecting the block sync code $SYNC_{BLK}$ is high.

As for the probability of generation of a false sync detection signal $ES_{SYNC}$ in the case of magnetization pattern where the sync code SYNC is prescribed, none of false sync detection signal $ES_{SYNC}$ is generated when no error is caused. Therefore, even if any one bit of the sync code SYNC is changed, the magnetization pattern posterior to such change is regarded as an existing data pattern.

Relative to the bit error rate Er and the bit length N of the sync code SYNC, the probability of occurrence of an error in a specified bit is expressed as

$$(1 - Er)^{N-1} \times Er \simeq (1 - (N - 1)\, Er) \times Er \qquad (3)$$

And if an error occurs in the specified bit, the probability of generation of a data pattern corresponding to the sync code SYNC becomes $1/2^N$ which is expressed as

$$\frac{(1 - (N - 1)\,Er) \times Er}{2^N} \quad (4)$$

Supposing now that the above calculation can be adapted for any one of N bits, the probability of generation of a false sync detection signal $ES_{SYNC}$ is expressed as

$$(1 - (N - 1)\,Er) \times Er \times N/2^N$$

$$\simeq N \times Er/2^N \quad (5)$$

Assume here that, as mentioned above, the bit error rate Er and the number N of bits of the sync code SYNC are set as

$$Er = 1 \times 10^{-4}$$

$$N = 36 \quad (6)$$

Then the probability of generation of a false sync detection signal $ES_{SYNC}$ is obtained as $5.2386 \times 10^{-14}$ by substituting Eq. (6) for Eq. (5).

The number of detections of the sync code SYNC per second is obtained from the following calculation.

$$880 \text{ (tracks)} \times 256 \text{ (blocks)} \times 166 \text{ (bytes)}$$

$$\times 9 \text{ (bits)} = 3.366 \times 10^8 \quad (7)$$

It is found therefore that the probability of generation of a false sync detection signal $ES_{SYNC}$ is once per 15.7 hours, signifying that the level is practically negligible unless any malfunction of the entire circuit is induced.

In the magnetic recording/reproducing apparatus employing the ID-1 format, the sync code SYNC is composed of 36 bits so that, if the probability of failure in detecting one sync code SYNC is once per record track TR, the probability of failure in detecting the top sync code $SYNC_{PR}$ due to random error corresponds to the probability of occurrence at the beginning of the record track TR. Consequently, a failure occurs once per 256 record tracks TR, i.e., 3 to 4 failures per second.

In this manner, if the top sync code $SYNC_{PR}$ fails to be detected, the data of the relevant one record track is regarded entirely as an error, so that the error of one bit of the sync code $SYNC_{PR}$ is multiplied by 165.

For the purpose of averting such a fault, in the sync detector circuit employed in the magnetic recording/reproducing apparatus or digital data recorder of this embodiment, the sync code SYNC also is once stored, together with the input data, in a predetermined buffer memory composed of a delay circuit, and interpolation of the sync code SYNC is executed retroactively to the instant of detection of the proper sync code SYNC, whereby the data is processed on the basis of such interpolated sync code SYNC.

Of the entire sync codes SYNC in the ID-1 format, the sync codes $SYNC_{PR}$ and $SYNC_{PS}$ of the preamble PR and the postamble PS are prescribed to 36 bits of the magnetization pattern "000011001 111111110 010111000 000001101", and the block sync code $SYNC_{BLK}$ of the data portion is prescribed to 36 bits of a magnetization pattern "111100110 000000001 101000111 111110010" (5.4 Helical Record Content, Format, Synchronization, and Recording Method, pp. 7 - 11).

Practically, for detecting such 36-bit sync code SYNC at a maximum repetition frequency of 88 MHz, it is necessary to compare the 36-bit data within 11 nsec, so that execution of such process is actually difficult even by using the known technique termed ECL logic. And with the aforementioned interpolation of the sync code SYNC retroactive to the past, detection of the sync code SYNC need not be executed in a real time mode.

In this embodiment, therefore, the input data is once converted into 9-bit parallel data prior to detection of the sync code SYNC, and an operation is performed to detect the position of the top bit of the sync code SYNC with regard to the entire bits and bytes of the relevant parallel data.

## First Embodiment

Denoted by 40 in Fig. 10 is a demodulator as a whole in the magnetic recording/reproducing apparatus or digital data recorder of the present invention, wherein a recorded signal on a magnetic tape is read out therefrom as a playback signal by means of a magnetic head, and playback digital data $DT_{PB}$ in a serial form binary-coded in a playback amplifier is inputted to a serial-to-parallel converter 41.

In the serial-to-parallel converter 41, the playback digital data $DT_{PB}$ inputted at the timing of parallel clock signal obtained by 1/9 frequency division of a serial clock signal for the playback digital data $DT_{PB}$ is divided into segments each composed of 9 bits, and the playback data $DT_{PB9}$ composed of the resultant 9-bit parallel data is inputted to an adjacent sync detector 42.

The sync detector 42 is so constituted as shown in Fig. 12, wherein the 9-bit playback data $DT_{PB9}$ is inputted sequentially into 1st through 5th flip-flops 43A - 43E, and 45-bit parallel data DT (A11 - A59) is obtained inclusive of the 9-bit output data from the flip-flops 43A - 43E, such as DT (A11 - A19), DT (A21-A29), DT (A31 - A39), DT (A41 - A49), and DT (A51 - A59).

The 45-bit parallel data DT (A11 - A59) is inputted to a 36-bit extractor 44 while its 2nd-byte output data (A31 - A39) is inputted to a sync position detector 45.

The sync position detector 45 is composed of a ROM (read-only memory) and is so formed as shown in Fig. 13, wherein the sync codes $SYNC_{PR}$, $SYNC_{PS}$ of the preamble PR and the postamble PS, and the block sync code $SYNC_{BLK}$ of the data portion, are sequentially shifted toward the least significant bit (LSB) by 0, 1, ...., 7 and 8 bits respectively, and the magnetization pattern obtained in the 2nd byte as a result of such shifts are stored correspondingly to the top bit positions S0 - S8 obtained by adding a value "1" to the individual amounts of shifts, thereby forming a preamble/postamble sync code detection table $TBL_{PR}$ and a data sync code detection table $TBL_{DT}$.

Therefore in the sync position detector 45, the preamble/postamble sync code detection table $TBL_{PR}$ and the data sync code detection table $TBL_{DT}$ are retrieved with respect to the 9 bits data of the 2nd byte output data DT (A31 - A39), and a detection is executed as to whether any magnetization pattern coincident with the output data DT (A31 - A39) is existent or not.

In case any magnetization pattern coincident with the output data DT (A31 - A39) is existent in the preamble/postamble sync code detection table $TBL_{PR}$ or the data sync code detection table $TBL_{DT}$, the top bit position signal S0 - S8 corresponding to such magnetization pattern is fed to a 36-bit extractor 44; and a sync code kind signal $S_{PRE}$, which signifies whether the magnetization pattern is the sync code $SYNC_{PR}$ or $SYNC_{PS}$ of the preamble PR or the postamble PS, or the block sync code $SYNC_{BLK}$ of the data portion DT, is fed to a 36-bit comparator 46.

In the sync position detector 45, the top bit position signal S0 - S8 is encoded and then is fed as sync position detection data $DT_{SYNCP}$ together with the sync code kind signal $S_{PRE}$.

In the 36-bit extractor 44, as shown in Fig. 14, 36-bit parallel data $DT_{36}$ is extracted from the 45-bit parallel data DT (A11 - A59) in accordance with the top bit position signal S0 - S8 inputted from the sync position detector 45, and then is fed to a 36-bit comparator 46.

The 36-bit comparator 46 has, as comparative reference patterns, a first data pattern $DT_{PTN1}$ ("000011001 111111110 010111000 000001101") relative to the sync codes $SYNC_{PR}$ and $SYNC_{PS}$ of the preamble PR and the postamble PS, and also a second data pattern $DT_{PTN2}$ ("111100110 000000001 101000111 111110010") relative to the sync code $SYNC_{BLK}$ of the data portion DT. And a detection is executed as to whether the 36-bit parallel data $DT_{36}$ fed from the 36-bit extractor 44 is coincident with the first or second data pattern $DT_{PTN1}$ or $DT_{PTN2}$ selected in accordance with the sync code kind signal $S_{PRE}$ fed from the sync position detector 45. And when a coincidence is attained between the compared data, the comparator 46 outputs a sync detection signal $S_{SYNC}$ which rises at the timing of such coincidence.

Practically, in this sync detector 42, the top bit position signal S0 - S8 obtained in the sync position detector 45 and the sync code kind signal $S_{PRE}$ merely signifying that the 1-byte output data DT (A31 - A39) inputted to the sync position detector 45 has a possibility of becoming a 2nd reference for the sync code SYNC.

Therefore, for exact detection of the sync code SYNC, the 36-bit parallel data $DT_{36}$ is extracted from the 45-bit parallel data DT (A11 - A59) in response to the top bit position signal S0 - S8 outputted from the sync position detector 45 and also to the sync code kind signal $S_{PRE}$, and such extracted data is compared with the data pattern $DT_{PTN1}$ or $DT_{PTN2}$ corresponding to the 36-bit sync code SYNC in accordance with the sync code kind signal $S_{PRE}$ inputted from the sync position detector 45, whereby a proper sync code SYNC can be detected.

In the sync detector 42, the 9-bit parallel data DT (A11 - A19) outputted via the 5th flip-flop 43E is fed to an NRZI/NRZ (non-return to zero inverse/non-return to zero) converter 47 which is composed of a combination of exclusive OR gates.

The NRZI/NRZ converter 47 produces an exclusive OR of mutually adjacent bits in a parallel data state. Then NRZI-to-NRZ conversion is executed with regard to the 9-bit parallel data DT (A11 - A19) of the NRZI code, whereby the 9-bit parallel data $DT_{NRZ}$ of the NRZ code is outputted.

In this manner, the 9-bit parallel data $DT_{NRZ}$ outputted from the sync detector circuit 42 is fed to a first delay circuit 50 which is composed of an FIFO (first-in first-out) memory and has a delay amount of 4 sync blocks.

In addition, there is also inputted, to the sync interpolator 51, the sync detection information $I_{SYNC}$ which is composed of the sync detection signal $S_{SYNC}$, the sync code kind signal $S_{PRE}$, and the sync position detection data $DT_{SYNCP}$ obtained from the sync detector 42.

The sync detection information $I_{SYNC}$ is fed to a second delay circuit 52A and first input terminals T1 of 1st to 4th switch circuits SW1 - SW4 each composed of a selector, and simultaneously the sync detection signal $S_{SYNC}$ included in the sync detection information $I_{SYNC}$ is inputted to a sync interval counter 53.

The sync interval counter 53 monitors the sync detection signal $S_{SYNC}$ at an interval of one sync block and counts the number of blocks where the sync detection signal $S_{SYNC}$ to be inputted periodically per sync block has not been inputted. And depending on the result of such count, a switch control signal $CNT_{SW}$ is outputted for selectively controlling the actions of the 1st through 4th switch circuits SW1 - SW4.

Delay sync detection information $I_{SYNC1}$ obtained from a 2nd delay circuit 52A is fed to a 2nd input terminal T2 of the 1st switch circuit SW1, and its output is fed to a 3rd delay circuit 52B.

Similarly to the above, delay sync detection information $I_{SYNC2}$ - $I_{SYNC4}$ obtained from the 3rd through 5th delay circuits 52B - 52D are fed respectively to the 2nd input terminals T2 of the 2nd through 4th switch circuits SW2 - SW4, and the outputs of the 2nd and 3rd switch circuits SW2 and SW3 are fed to the 4th and 5th delay circuits 52C and 52D.

Each of the 2nd through 5th delay circuits 52A-52D is composed of an FIFO memory similarly to the 1st delay circuit 50 and has a delay amount corresponding to one sync block.

Therefore, when the input sync detection information $I_{SYNC}$ passes via the entire 2nd through 5th delay circuits 52A - 52D, i.e., when the 2nd input terminals T2 of the 1st through 4th switch circuits SW1 - SW4 are selected by the switch control signal $CNT_{SW}$, obtained by the sync interval counter 53, then the delay amount is rendered equal to the 9-bit parallel data $DT_{NRZ}$ delayed by the 1st delay circuit 50.

Accordingly, in case the sync detection signal $S_{SYNC}$ fails to be detected during a time corresponding to one sync block for example, the sync interval counter 53 produces a switch control signal $CNT_{SW}$ which serves to select the 1st input terminal T1 of merely the 1st switch circuit SW1 alone while selecting the 2nd input terminals T2 of the 2nd through 4th switch circuits SW2 - SW4. In this manner, only the sync detection information $I_{SYNC}$ alone is delayed for a time corresponding to three sync blocks, whereby interpolation is performed with regard to the sync detection information $I_{SYNC}$ not detected.

In the sync interval counter 53, as shown in Fig. 11, the 1st or 2nd input terminals T1 or T2 of the 1st through 4th switch circuits SW1 - SW4 are selected under control in accordance with the number of the sync blocks where the sync detection signal $S_{SYNC}$ has not been detected, so that interpolation can be achieved up to a maximum of four sync blocks in the case of failure in detecting the signal $S_{SYNC}$.

Further in the sync interpolator 51, if the sync detection signal $S_{SYNC}$ fails to be detected for a time longer than five sync blocks, the sync detection signal $S_{SYNC}$ included in the delay sync detection information $I_{SYNC4}$ outputted from the 4th switch circuit SW4 is fed to a flywheel counter 54, so that the sync detection information $I_{SYNC}$ can be interpolated on the basis of the preceding sync detection information $I_{SYNC}$ properly detected last.

Thus, the sync interpolator 51 is so constituted that, when the sync detection signal $S_{SYNC}$ fails to be detected for a time corresponding to a maximum of four sync blocks, the past sync information $I_{SYNC}$ is interpolated by the use of new sync information $I_{SYNC}$. And when the sync detection signal $S_{SYNC}$ fails to be detected for more than a time corresponding to five sync blocks, new sync information $I_{SYNC}$ is interpolated by using the past sync information $I_{SYNC}$. In this manner, the sync information $I_{SYNC}$ can be interpolated practically with a sufficient precision, and the sync information $I_{SYNC}$ is supplied to a 9-18-9 converter 55, while the sync detection signal $S_{SYNC}$ included in the sync information $I_{SYNC}$ is inputted to a block counter (not shown) which generates a write address for a memory (not shown).

First, in the 9-18-9 converter 55, 18-bit data is produced out of two bytes by sequentially shifting, byte by byte, the 9-bit parallel data $DT_{NRZI}$ of four sync blocks inputted with delay from the 1st delay circuit 50.

Subsequently in the 9-18-9 converter 55, 9-bit data is extracted from the 18-bit data, by the same technique as adopted in the 36-bit extractor 44 (Fig. 12), on the basis of the sync position detection data $DT_{SYNCP}$ included in the sync detection information $I_{SYNC}$ inputted from the sync interpolator 51, thereby producing 9-bit parallel data $DT_{NRZ2}$ divided at proper bit positions in accordance with the sync position detection data $DT_{SYNCP}$, and the parallel data $DT_{NRZ2}$ thus obtained is fed to a next 8-9 demodulator 56.

The 8-9 demodulator 56 is composed of a ROM where the code conversion table is stored. And 8-bit parallel data $DT_{PB8}$ obtained from the input 9-bit parallel data $DT_{NRZ2}$ on the basis of the ID-1 format is stored in the memory in accordance with the memory address outputted from the block counter.

According to the above constitution, when the sync code of a 36-bit length is detected from the playback data, the playback data is converted to 9-bit parallel data at a desired timing, and the top position of the sync code is predicted by continuously monitoring one byte of the parallel data. And 36-bit parallel data conforming to the sync code is extracted in accordance with the result of such prediction and then is compared with the sync code data pattern, whereby the sync code of a 36-bit length can be accurately detected in the simplified constitution.

In case the sync code fails to be detected, the sync detection information is interpolated retroactively to the past on the basis of the sync detection information of the sync code detected posterior to such failure, so that interpolation of the sync detection information is achieved with certain detection of the sync code.

Thus, it becomes possible to realize a magnetic recording/reproducing apparatus or a digital data recorder which is capable of processing the playback data by properly detecting the sync code even when the sync code in the playback data has a considerable length of 36 bits.

## Second Embodiment

Denoted by 60 in Fig. 15 is a demodulator in a second embodiment of the present invention, wherein the components corresponding to those in Fig. 10 are denoted by the same reference numerals and symbols. In this example, a sync interpolator 61 is fed with sync detection information $I_{SYNC}$ which is composed of a sync detection signal $S_{SYNC}$, a sync code kind signal $S_{PRE}$, and sync position detection data $DT_{SYNCP}$ outputted from a sync detector 42.

The sync detection information $I_{SYNC}$ is inputted to both a 6th delay circuit 62A and a 5th input terminal T15 of a 5th switch circuit SW5 composed of a selector, while the sync detection signal $S_{SYNC}$ included in the sync detection information $I_{SYNC}$ is inputted to both a flywheel counter 63 and a sync timing detector 64.

The delayed sync detection information $I_{SYNC1}$ outputted from a 6th delay circuit 62A is fed to both a 7th delay circuit 62B and a 4th input terminal T14 of a 5th switch circuit SW5, while the sync detection signal $S_{SYNC1}$ included in the delayed sync detection information $I_{SYNC1}$ is inputted to a sync timing detector 64.

Similarly, the delayed sync detection information $I_{SYNC2}$ and $I_{SYNC3}$ outputted from the 7th and 8th delay circuits 62B, 62C are fed respectively to 8th and 9th delay circuits 62C, 62D and also to 3rd and 2nd input terminals T13, T12 of the 5th switch circuit SW5. And simultaneously the sync detection signal $S_{SYNC2}$ and $S_{SYNC3}$ included respectively in the delayed sync detection information $I_{SYNC2}$ and $I_{SYNC3}$ are fed to a sync timing detector 64.

Further similarly to the above, the delayed sync detection information $I_{SYNC4}$ outputted from a 9th delay circuit 62D is fed to a 1st input terminal T11 of the 5th switch circuit SW5, and the sync detection signal $S_{SYNC4}$ included in the delayed sync detection information $I_{SYNC4}$ is fed to a sync timing detector 64.

The flywheel counter 63 receives the sync detection signal $S_{SYNC}$ included in the sync detection information $I_{SYNC}$ and generates, out of the sync detection signal $S_{SYNC}$ properly detected last, a sync interpolation signal $SH_{SYNC}$ conforming to the timing of such sync detection signal $S_{SYNC}$. The signal $SH_{SYNC}$ thus generated is then fed to the 6th input terminal T16 of the 5th switch circuit SW5.

Practically, the sync timing detector 64 outputs a switch control signal $CNT_{SW5}$ for selecting the 1st - 6th input terminals T11 - T16 of the 5th switch circuit SW5 as shown in Fig. 16, in accordance with the sync detection signals $S_{SYNC}$ and $S_{SYNC1}$ - $S_{SYNC4}$ included respectively in the sync detection information $I_{SYNC}$ and the delayed sync detection information $I_{SYNC1}$ - $I_{SYNC4}$.

In Fig. 16, there are shown the 1st - 6th input terminals T11 - T16 of the 5th switch circuit SW5 selected by the switch control signal $CNT_{SW5}$ outputted from the sync timing detector 64, wherein a value "1" represents the presence of the sync detection signal $S_{SYNC}$ or $S_{SYNC1}$ - $S_{SYNC4}$, while a value "0" represents the absence of such signal, and a sign "x" represents a state irrelative to the presence or absence thereof.

Due to such constitution, when the sync detection signal $S_{SYNC}$ fails to be detected during a time corresponding to one sync block for example, i.e., when the sync detection signal $S_{SYNC4}$ to be outputted from the 9th delay circuit 62D for example is not present, then the sync timing detector 64 generates a switch control signal $CNT_{SW5}$ for selecting the 2nd input terminal T2 to delay only the sync detection information $I_{SYNC}$ for a time corresponding to three sync blocks, thereby interpolating the sync detection information $I_{SYNC}$ not detected.

Similarly to the above, in the sync interpolator 61, the sync detection information $I_{SYNC}$ and the delayed sync detection information $I_{SYNC1}$ - $I_{SYNC4}$ are selectively inputted in case the sync detection signal $S_{SYNC}$ fails to be detected for a time corresponding to a maximum of four sync blocks, whereby desired interpolation can be performed.

Further in the sync interpolator 61, if the sync detection signal $S_{SYNC}$ fails to be detected for more than a time corresponding to five sync blocks, the 6th input terminal T16 is selected for outputting the sync interpolation signal $SH_{SYNC}$ obtained from the flywheel counter 63, whereby the sync detection information $I_{SYNC}$ can be interpolated on the basis of the preceding sync detection information $I_{SYNC}$ properly detected last.

According to the constitution mentioned above, upon occurrence of a failure in detecting the sync code, the sync detection information is interpolated retroactively to the past on the basis of the sync detection information of the sync code detected thereafter, so that interpolation of the sync detection information can be achieved with accurate detection of the sync code.

Thus, it becomes possible to realize, as in the aforementioned first embodiment, a magnetic recording/reproducing apparatus which is capable of processing the playback data by properly detecting the sync code even when the sync code in the playback data has a considerable length of 36 bits.

In the above preferred embodiments, delay circuits for four sync blocks are disposed in the playback data transmitting system, and also delay circuits for four sync blocks are arranged in the sync interpolator in conformity therewith to perform sync interpolation. However, the amount of delay in each of the playback data transmitting system and the sync interpolator may be selectively changed in compliance with any adequate number of sync blocks conforming to individual requirements.

The foregoing embodiments have been described in connection with an exemplary case of applying the present invention to a magnetic recording/reproducing apparatus or digital data recorder employing the ID-1 format. It is to be understood, however, that the present invention is not limited to such embodiments alone and may be widely applied to any apparatus which transmits information data by dividing the same into segments with a sync code of a relatively great bit length.

## Claims

1. An apparatus for transmitting digital data inclusive of information data and synchronous data, said synchronous data having a code of a plurality of bytes arranged in a code of a plurality of bytes of said information data, said apparatus comprising:

    a serial-to-parallel converter (41) for converting a serial data stream of said digital data to a parallel data stream at an arbitrary timing of bit of said digital data;
a detector (45) for detecting a position of the first-byte code of said synchronous data by comparing each byte of said parallel data stream with one predetermined byte of said synchronous data;
an extractor (44) for extracting said synchronous data having a code of a plurality of bytes from said parallel data stream in response to an output signal of said detector; and
a comparator (46) for comparing said extracted synchronous data with a predetermined pattern of said plurality of bytes of synchronous data,

**characterized in**
that a signal indicating an amount of the bit shift of said extracted synchronous data from said predetermined pattern is output by said detector (42) in case the result of said comparison is positive.

2. An apparatus according to claim 1, wherein said detector (45) outputs a bit shift signal to said extractor (44).

3. An apparatus according to claim 1 or 2, wherein a signal is output from the apparatus comprising said bit shift signal from said detector (45) and a detection signal from said comparator (46) indicating the result of said comparison.

4. An apparatus according to any one of the preceding claims, wherein said detector (45) furthermore outputs a signal to said comparator (46) indicating the kind of said first-byte code.

## Patentansprüche

1. Vorrichtung zur Übertragung von Digitaldaten, die Informationsdaten und Synchronisierungsdaten enthalten, wobei die Synchronisierungsdaten einen Code aus mehreren Byte aufweisen, die in einem Code mit mehreren Bytes der Informationsdaten angeordnet sind, wobei die Vorrichtung aufweist:

einen Seriell-Parallel-Umsetzer (41) zur Umsetzung eines Seriendatenstromes der Digitaldaten in einen parallelen Datenstrom mit einer beliebigen Bildtaktung der Digitaldaten,
einen Detektor (45) zur Erfassung der Position des Codes des ersten Bytes der Synchrondaten durch Vergleich von jedem Byte des parallelen Datenstroms mit einem vorbestimmten Byte der Synchronisierungsdaten,
einem Extraktor (44) zum Extrahieren der Synchronisierungsdaten, die einen Code aus mehreren Byte aufweisen, aus dem parallelen Datenstrom als Antwort auf ein Ausgabesignal des Detektors, und
einen Komparator (46) zum Vergleich der extrahierten Synchronisierungsdaten mit einem vorbestimmten Muster der mehreren Byte der Synchronisierungsdaten,

**dadurch gekennzeichnet**, daß ein Signal, das einen Bitverschiebungswert der extrahierten Synchrondaten von dem vorbestimmten Muster anzeigt, durch den Detektor (42) für den Fall ausgegeben wird, daß der Vergleich positiv ist.

2. Vorrichtung nach Anspruch 1, bei der der Detektor (45) ein Bitverschiebungssignal zu dem Extraktor (44) gibt.

3. Vorrichtung nach Anspruch 1 oder 2, bei der ein Signal von der Vorrichtung ausgegeben wird, das ein Bitverschiebungssignal von dem Detektor (45) und ein Erfassungssignal von dem Komparator (46) enthält, das das Ergebnis des Vergleichs anzeigt.

4. Vorrichtung nach einem der vorhergehenden Ansprüche, bei dem der Detektor (45) weiterhin ein Signal zu dem Komparator (46) ausgibt, das die Art des Codes des ersten Bytes anzeigt.

## Revendications

1. Dispositif pour la transmission de données numériques comprenant des données d'information et des données synchrones, lesdites données synchrones possédant un code d'une pluralité d'octets agencés en un code d'une pluralité d'octets desdites données d'information, ledit dispositif comprenant :

- un convertisseur série/parallèle (41) pour la conversion d'une suite de données en série desdites données numériques en une suite de données en parallèle selon un calage dans le temps arbitraire des bits desdites données numériques;
- un détecteur (45) pour la détection d'une position du code de premier octet desdites données synchrones par comparaison de chaque octet de ladite suite de données en parallèle avec un octet prédéterminé desdites données synchrones;
- un extracteur (44) pour extraire lesdites données synchrones possédant un code d'une pluralité d'octets à partir de ladite suite de données en parallèle en réponse à un signal de sortie dudit détecteur; et
- un comparateur (46) pour comparer lesdites données synchrones extraites avec une configuration prédéterminée de ladite pluralité d'octets de données synchrones;

dispositif caractérisé en ce qu'un signal indiquant une valeur de décalage binaire desdites données synchrones extraites à partir de ladite configuration prédéterminée est généré par ledit détecteur (42) dans le cas d'un résultat positif de ladite comparaison.

**2.** Dispositif selon la revendication 1, dans lequel ledit détecteur (45) génère un signal de décalage binaire vers ledit extracteur (44).

**3.** Dispositif selon la revendication 1 ou 2, dans lequel un signal est généré par le dispositif comprenant ledit signal de décalage binaire dudit détecteur (45) et un signal de détection dudit comparateur (46) indiquant le résultat de ladite comparaison.

**4.** Dispositif selon l'une quelconque des revendications précédentes, dans lequel ledit détecteur (45) génère, de plus, un signal vers ledit comparateur (46) indiquant le type dudit code de premier octet.

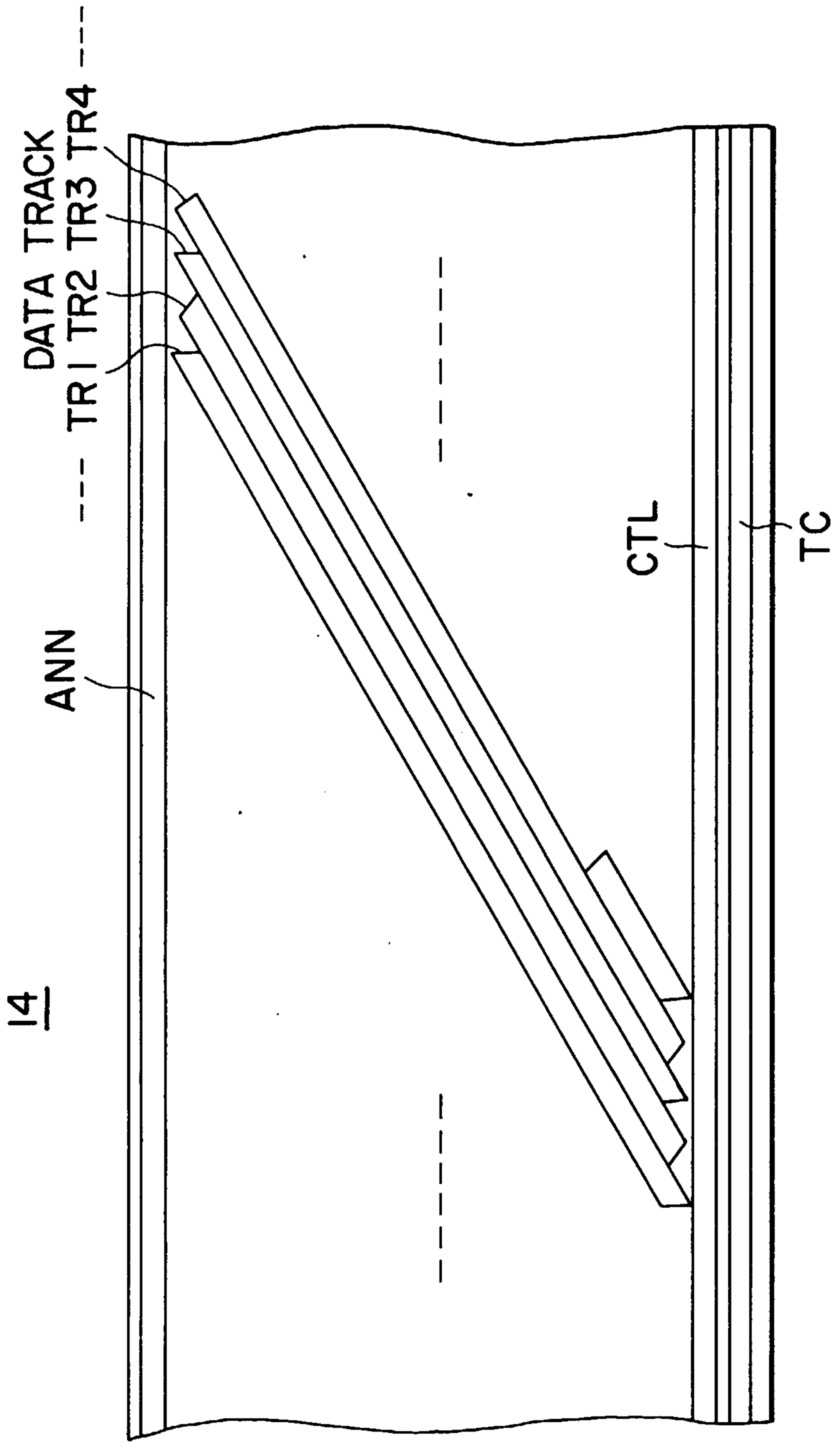


FIG. 1

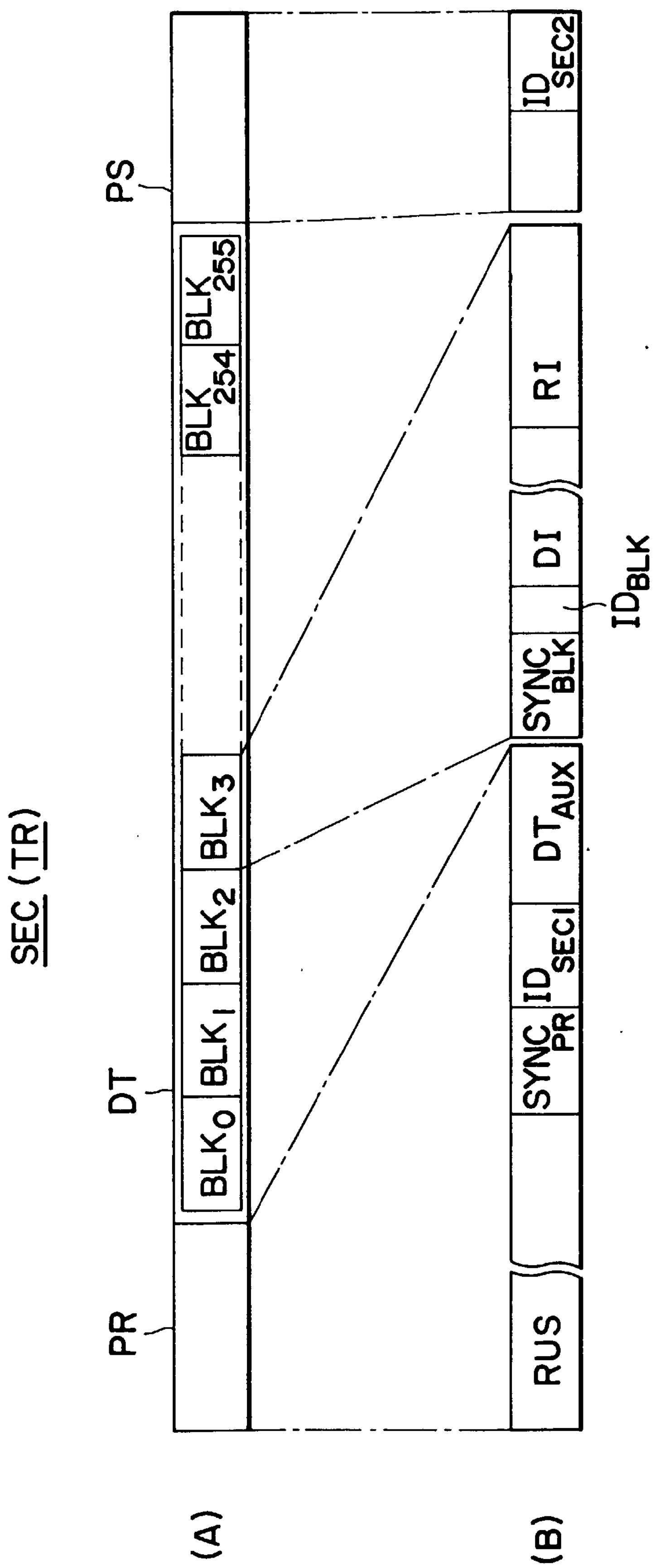
SEC (TR)
PR
DT
PS
BLK0
BLK1
BLK2
BLK3
BLK254
BLK255
(A)
(B)
RUS
SYNC PR
ID SEC1
DT AUX
SYNC BLK
ID BLK
DI
RI
ID SEC2

FIG. 2

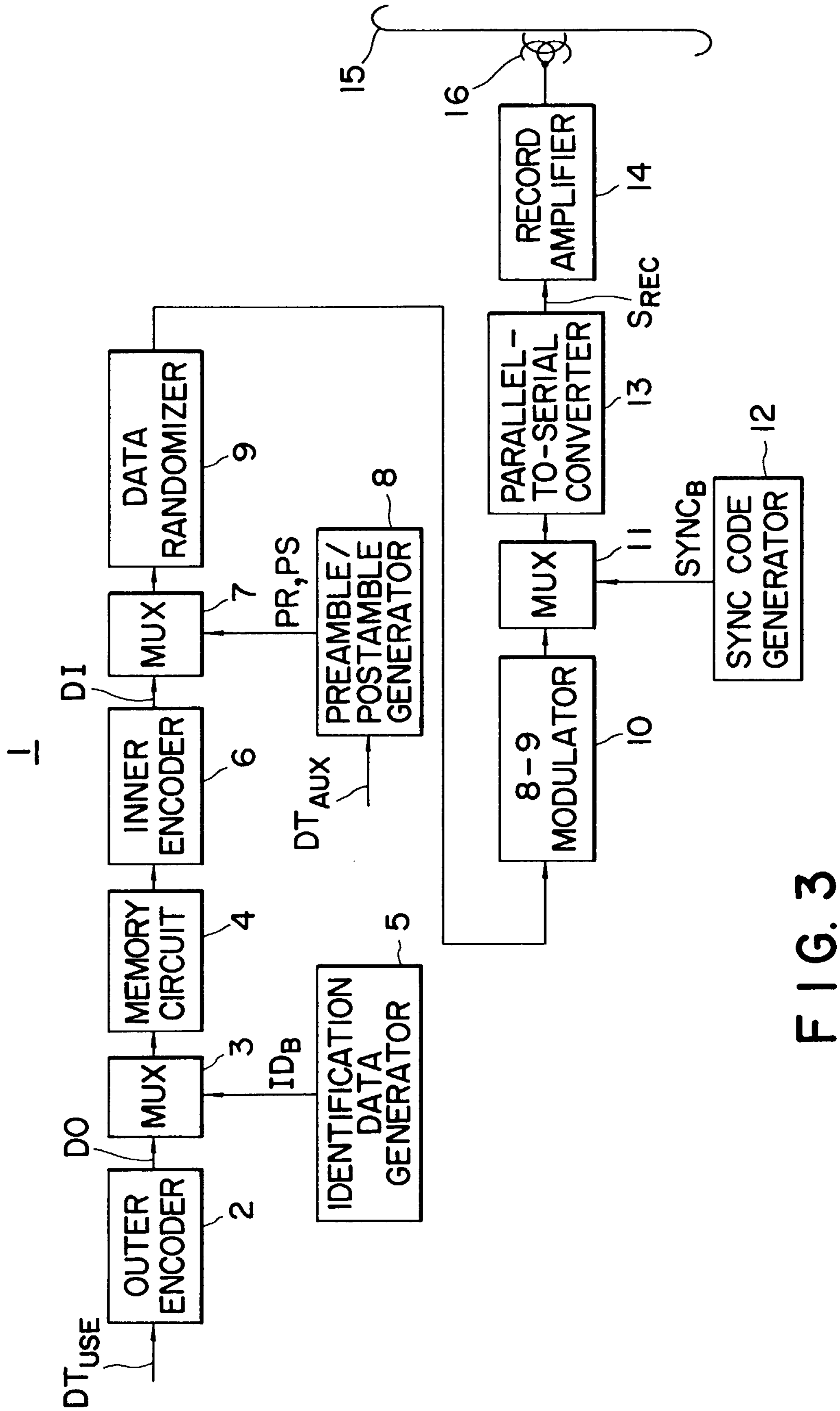
1
$DT_{USE}$
OUTER ENCODER
2
DO
MUX
3
$ID_B$
IDENTIFICATION DATA GENERATOR
5
MEMORY CIRCUIT
4
INNER ENCODER
6
DI
MUX
7
PR,PS
PREAMBLE / POSTAMBLE GENERATOR
8
$DT_{AUX}$
DATA RANDOMIZER
9
8-9 MODULATOR
10
MUX
11
$SYNC_B$
SYNC CODE GENERATOR
12
PARALLEL-TO-SERIAL CONVERTER
13
$S_{REC}$
RECORD AMPLIFIER
14
15
16

FIG. 3

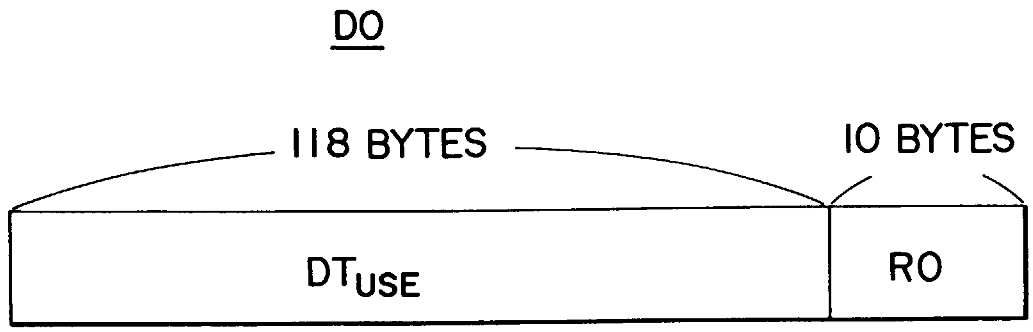


FIG. 4

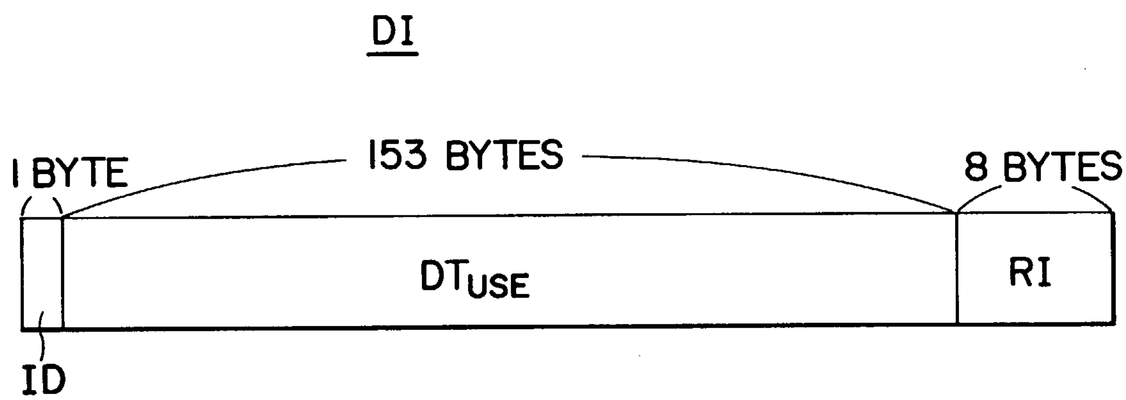


FIG. 6

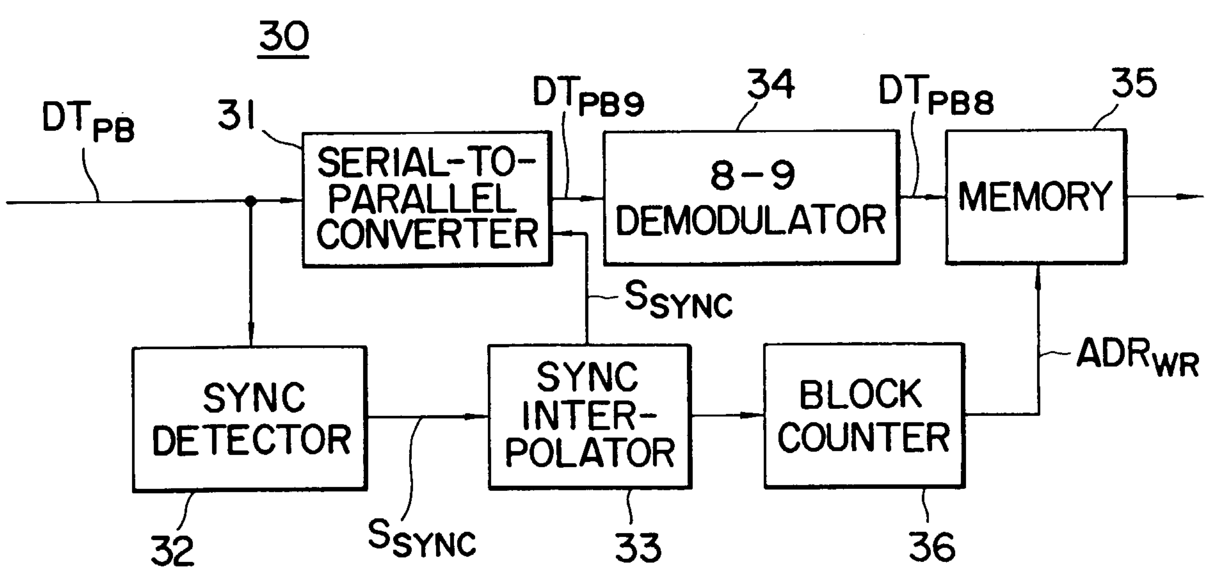


FIG. 9

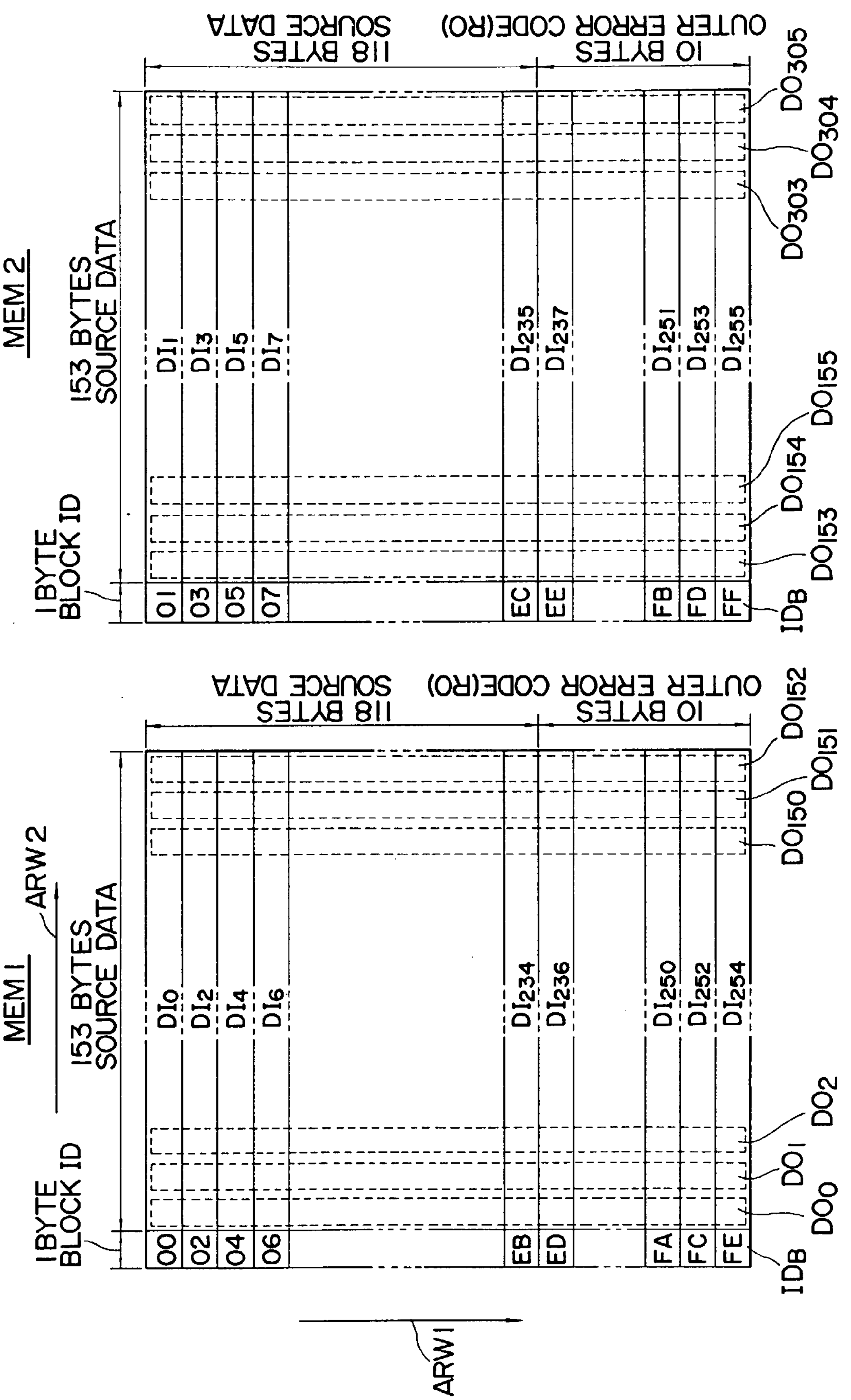
MEM 1
MEM 2
1 BYTE BLOCK ID
153 BYTES SOURCE DATA
118 BYTES SOURCE DATA
10 BYTES OUTER ERROR CODE(RO)
ARW1
ARW2
IDB
00 02 04 06 EB ED FA FC FE
01 03 05 07 EC EE FB FD FF
DI0 DI2 DI4 DI6 DI234 DI236 DI250 DI252 DI254
DI1 DI3 DI5 DI7 DI235 DI237 DI251 DI253 DI255
DO0 DO1 DO2 DO150 DO151 DO152
DO153 DO154 DO155 DO303 DO304 DO305

FIG. 5

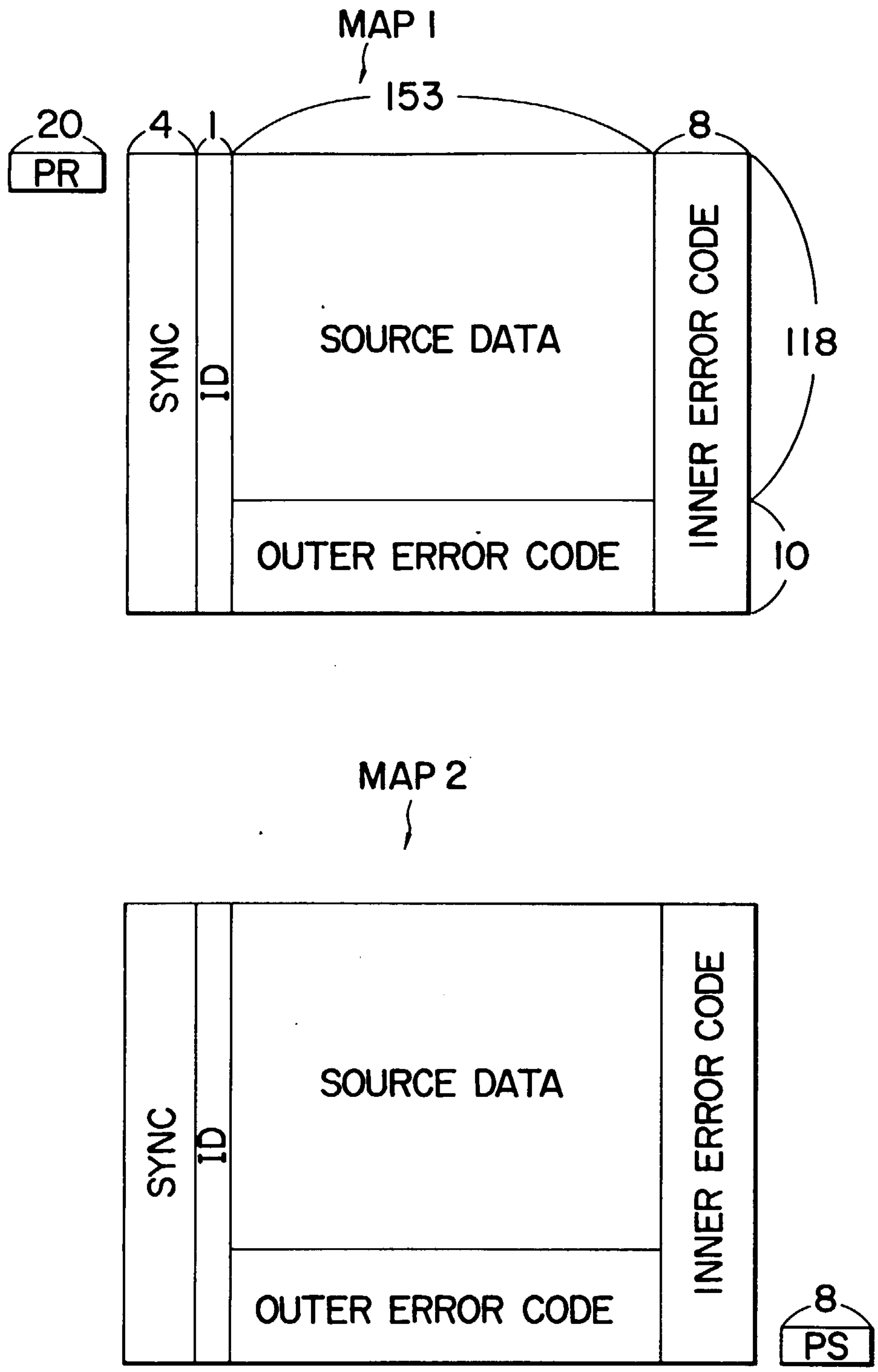
MAP 1
153
20
PR
4
1
8
SYNC
ID
SOURCE DATA
INNER ERROR CODE
118
OUTER ERROR CODE
10
MAP 2
SYNC
ID
SOURCE DATA
INNER ERROR CODE
OUTER ERROR CODE
8
PS

FIG. 7

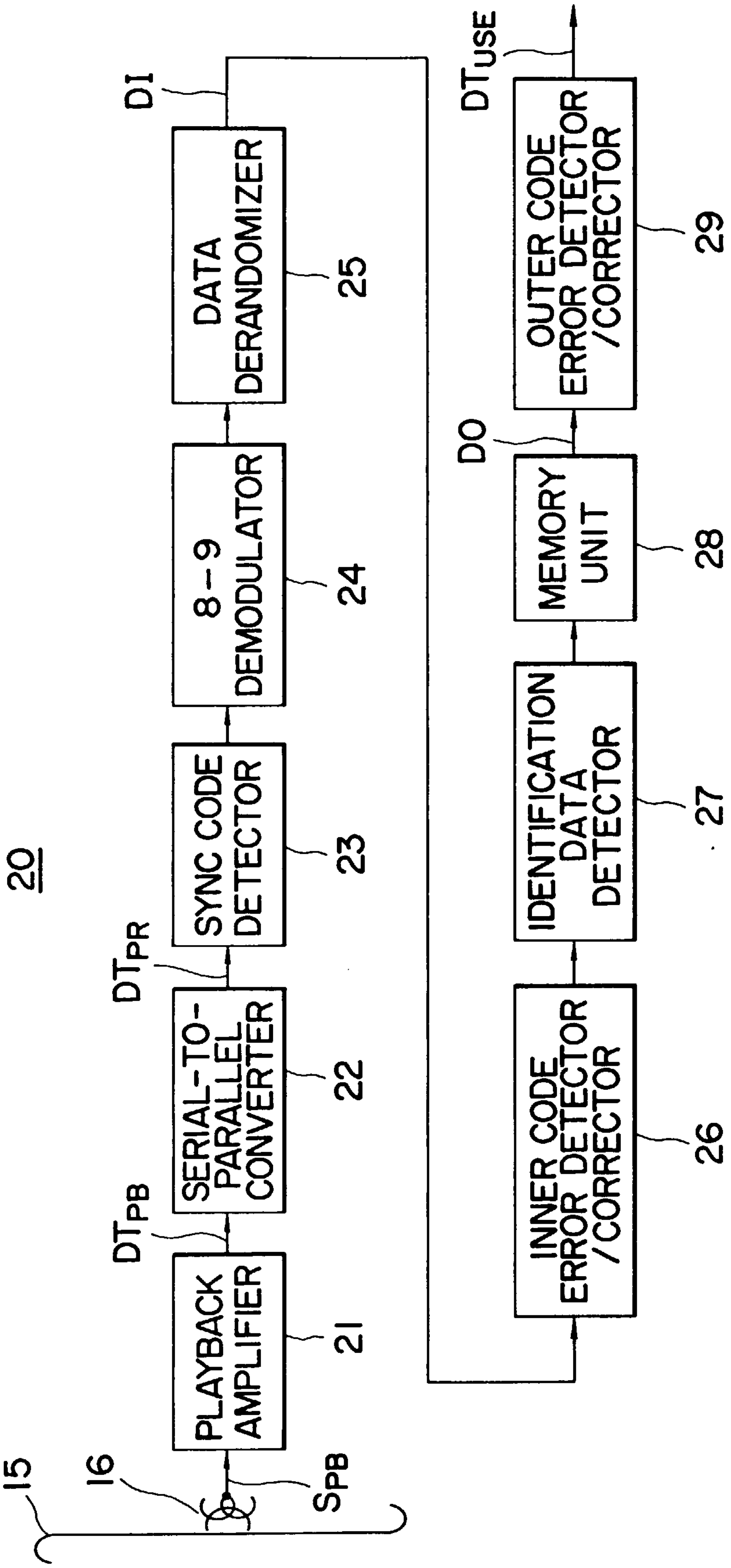
20
15
16
SPB
PLAYBACK AMPLIFIER
21
DTPB
SERIAL-TO-PARALLEL CONVERTER
22
DTPR
SYNC CODE DETECTOR
23
8-9 DEMODULATOR
24
DATA DERANDOMIZER
25
DI
INNER CODE ERROR DETECTOR /CORRECTOR
26
IDENTIFICATION DATA DETECTOR
27
MEMORY UNIT
28
DO
OUTER CODE ERROR DETECTOR /CORRECTOR
29
DTUSE

FIG.8

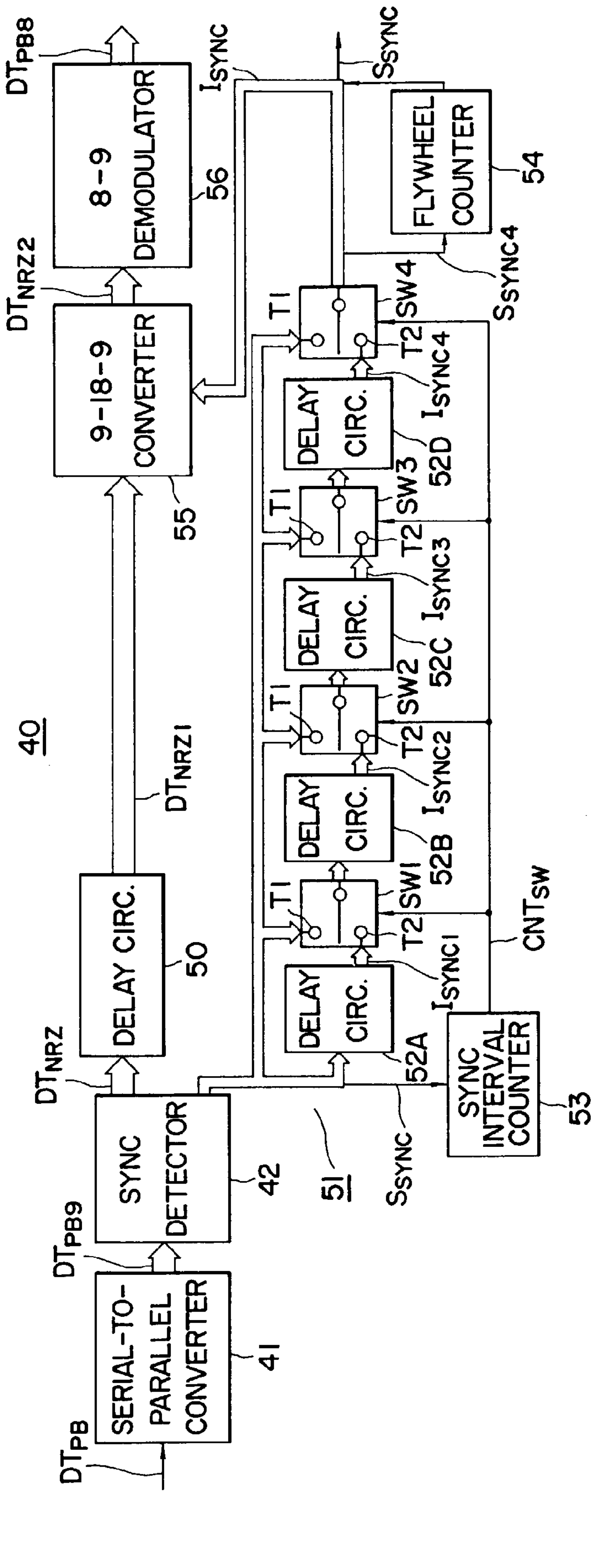
$DT_{PB}$
SERIAL-TO-PARALLEL CONVERTER
41
$DT_{PB9}$
SYNC DETECTOR
42
$DT_{NRZ}$
DELAY CIRC.
50
$DT_{NRZ1}$
40
9-18-9 CONVERTER
55
$DT_{NRZ2}$
8-9 DEMODULATOR
56
$DT_{PB8}$
$I_{SYNC}$
51
$S_{SYNC}$
DELAY CIRC.
52A
$I_{SYNC1}$
T1
T2
SW1
DELAY CIRC.
52B
$I_{SYNC2}$
T1
T2
SW2
DELAY CIRC.
52C
$I_{SYNC3}$
T1
T2
SW3
DELAY CIRC.
52D
$I_{SYNC4}$
T1
T2
SW4
$S_{SYNC4}$
FLYWHEEL COUNTER
54
$S_{SYNC}$
SYNC INTERVAL COUNTER
53
$CNT_{SW}$

FIG. 10

| INTERVAL | SW1 | SW2 | SW3 | SW4 |
|---|---|---|---|---|
| 0 BLOCK | T2 | T2 | T2 | T2 |
| 1 BLOCK | T1 | T2 | T2 | T2 |
| 2 BLOCK | T1 | T1 | T2 | T2 |
| 3 BLOCK | T1 | T1 | T1 | T2 |
| 4 BLOCK | T1 | T1 | T1 | T2 |

FIG. 11

| TERMINAL | $S_{SYNC}$ | $S_{SYNC1}$ | $S_{SYNC2}$ | $S_{SYNC3}$ | $S_{SYNC4}$ |
|---|---|---|---|---|---|
| T11 | x | x | x | x | 1 |
| T12 | x | x | x | 1 | 0 |
| T13 | x | x | 1 | 0 | 0 |
| T14 | x | 1 | 0 | 0 | 0 |
| T15 | 1 | 0 | 0 | 0 | 0 |
| T16 | 0 | 0 | 0 | 0 | 0 |

FIG. 16

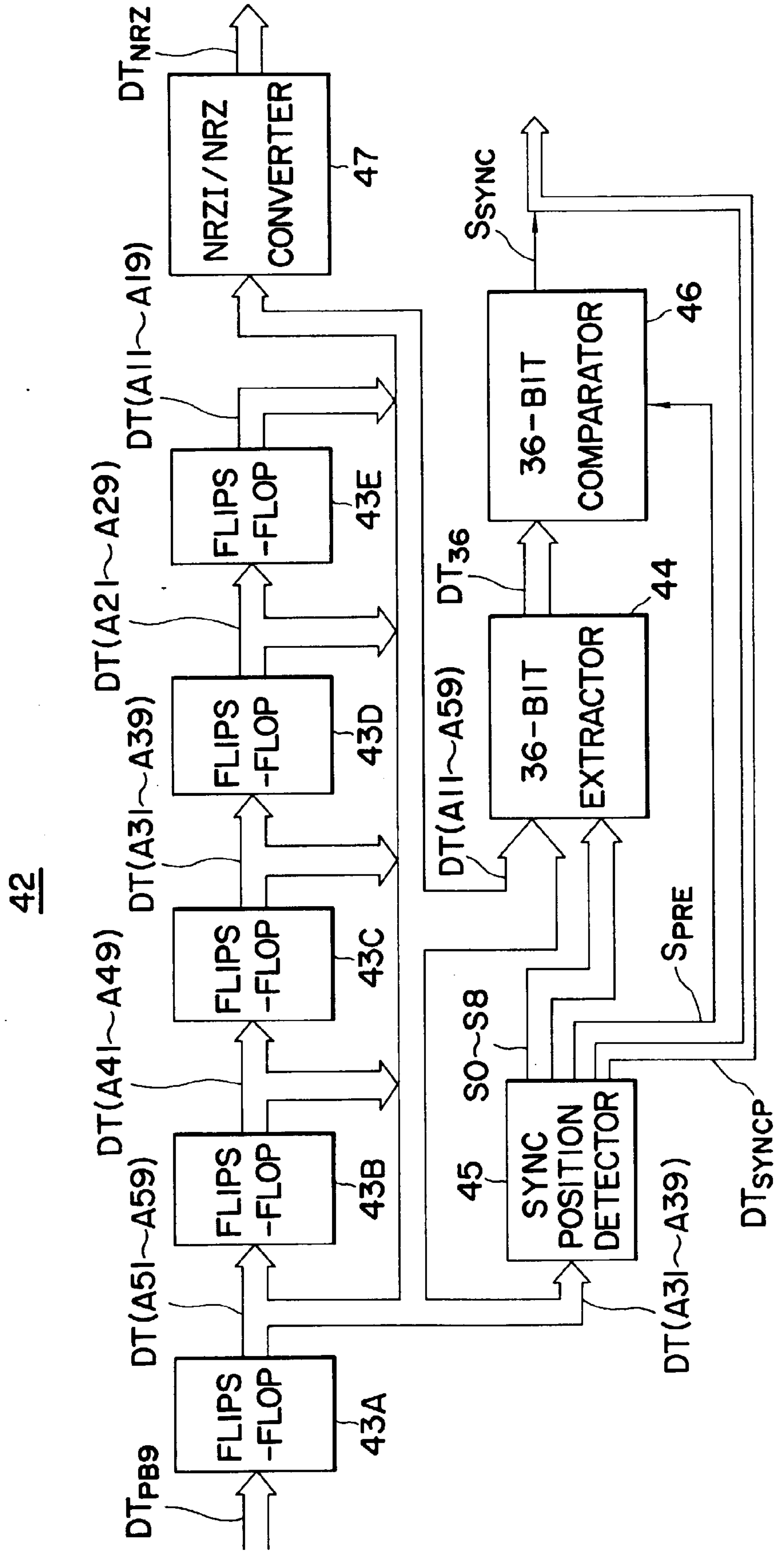
42
DTPB9
FLIPS -FLOP
43A
DT(A51~A59)
FLIPS -FLOP
43B
DT(A41~A49)
FLIPS -FLOP
43C
DT(A31~A39)
FLIPS -FLOP
43D
DT(A21~A29)
FLIPS -FLOP
43E
DT(A11~A19)
NRZI/NRZ CONVERTER
47
DTNRZ
45
SYNC POSITION DETECTOR
DT(A31~A39)
SO~S8
DTSYNCP
SPRE
DT(A11~A59)
36-BIT EXTRACTOR
44
DT36
36-BIT COMPARATOR
46
SSYNC

F I G. 12

| TOP BIT POSITION | BLOCK SYNC CODE ($TBL_{DT}$) | P. / P. SYNC CODE ($TBL_{PR}$) |
|---|---|---|
| 1 | 000000001 | 111111110 |
| 2 | 000000011 | 111111100 |
| 3 | 000000110 | 111111001 |
| 4 | 000001101 | 111110010 |
| 5 | 000011010 | 111100101 |
| 6 | 000110100 | 111001011 |
| 7 | 001101000 | 110010111 |
| 8 | 011010001 | 100101110 |
| 9 | 110100011 | 001011100 |

FIG. 13

| SHIFT SIGNAL | EXTRACTED BIT |
|---|---|
| S0 | A11 – A49 |
| S1 | A12 – A51 |
| S2 | A13 – A52 |
| S3 | A14 – A53 |
| S4 | A15 – A54 |
| S5 | A16 – A55 |
| S6 | A17 – A56 |
| S7 | A18 – A57 |
| S8 | A19 – A58 |

FIG. 14

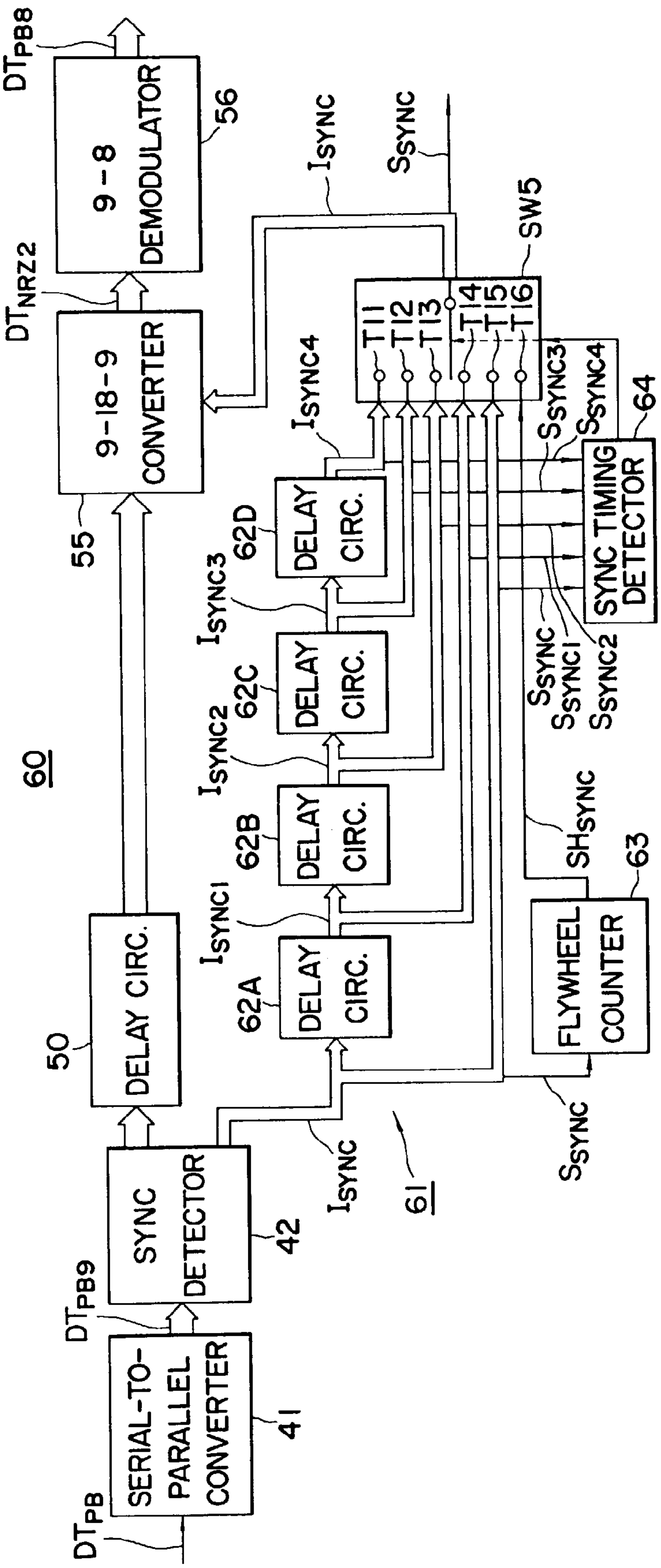
60
$DT_{PB}$
SERIAL-TO-PARALLEL CONVERTER
41
$DT_{PB9}$
SYNC DETECTOR
42
$I_{SYNC}$
61
50
DELAY CIRC.
55
9-18-9 CONVERTER
$DT_{NRZ2}$
9 - 8 DEMODULATOR
56
$DT_{PB8}$
62A
DELAY CIRC.
$I_{SYNC1}$
62B
DELAY CIRC.
$I_{SYNC2}$
62C
DELAY CIRC.
$I_{SYNC3}$
62D
DELAY CIRC.
$I_{SYNC4}$
$I_{SYNC}$
$S_{SYNC}$
SW5
T11
T12
T13
T14
T15
T16
$S_{SYNC3}$
$S_{SYNC4}$
64
SYNC TIMING DETECTOR
$S_{SYNC}$
$S_{SYNC1}$
$S_{SYNC2}$
$SH_{SYNC}$
63
FLYWHEEL COUNTER
$S_{SYNC}$

FIG. 15